# EUROPEAN PATENT APPLICATION

(11) **EP 4 443 489 A1**
(43) Date of publication of application: **09.10.2024**
(21) Application number: 24168225.1
(22) Date of filing: 03.04.2024
(51) Int. Cl.: H01L 23/00, B23K 35/02, B22F 7/00

(54) **SINTER BONDING SHEET**

(30) Priority: 06.04.2023 JP 2023061892; 13.02.2024 JP 2024019696
(71) Applicant: NITTO DENKO CORPORATION, Ibaraki-shi Osaka 567-8680 (JP)
(72) Inventor: Mita, Ryota, Ibaraki-shi, Osaka, 567-8680 (JP); Okoba, Yuichi, Ibaraki-shi, Osaka, 567-8680 (JP)
(74) Representative: Grünecker Patent- und Rechtsanwälte PartG mbB

(57) **Abstract**

A sinter bonding sheet includes a sinter bonding layer that includes sinterable particles containing a conductive metal, and an organic binder, in which the sinter bonding layer has a first adhesive surface for being adhered to an adherend and a second adhesive surface for being adhered to another adherend, and when the value of the minimum load reached during an unloading step in a load-displacement measurement according to the nanoindentation method to the first adhesive surface is b1, and the value of the minimum load reached during the unloading step in the load-displacement measurement according to the nanoindentation method to the second adhesive surface is b2, b1 satisfies -100 µN≤b1≤-35 µN and b2 satisfies -100 µN≤b2≤-35 µN.

## Description

### FIELD OF THE INVENTION

The present invention relates to a sinter bonding sheet. Specifically, the present invention relates to a sinter bonding sheet having a sinter bonding layer for bonding, by sintering, a semiconductor device on a substrate having a semiconductor device mounting area.

### BACKGROUND OF THE INVENTION

There is conventionally known a method for mounting a semiconductor device on a substrate having a semiconductor device mounting area by means of a sinter bonding layer in producing a semiconductor apparatus (for example, JP 2020-150188 A). JP 2020-150188 A describes that the sinter bonding layer is formed as a layer including sinterable particles and an organic binder.

The production of the semiconductor apparatus as aforementioned is performed, for example, with the following steps.
(1) A semiconductor wafer is attached to an adhesive layer of a dicing tape that includes a substrate and the adhesive layer laminated on the substrate. Then, the semiconductor wafer that is attached to the adhesive layer is subjected to dicing to be formed into a plurality of individual semiconductor devices.
(2) One semiconductor device is picked up using a jig such as a collet from the adhesive layer of the dicing tape. Then, the one semiconductor device is pressed onto a sinter bonding layer provided in a sinter bonding sheet, to cut a part of the sinter bonding layer into segments each having a size corresponding to the size of the one semiconductor device. The sinter bonding layer divided as described above is adhered to the one semiconductor device by an organic binder that exists on a surface in abutting contact with the one semiconductor device, to thereby allow the divided sinter bonding layer to be transferred to the one semiconductor device.
(3) The one semiconductor device, to which the divided sinter bonding layer is transferred, is adhered to one semiconductor device mounting area on the substrate having a plurality of semiconductor device mounting areas by the organic binder that exists on a surface on the opposite side to the surface in abutting contact with the one semiconductor device. That is, the one semiconductor device is temporarily fixed to the one semiconductor device mounting area of the substrate by the organic binder.
(4) The steps in the above (2) and (3) are repeated several times, to thereby allow the plurality of semiconductor devices to be temporarily fixed to the plurality of semiconductor device mounting areas by the divided sinter bonding layers, respectively. Thereby, an intermediate product of the semiconductor apparatus is obtained.
(5) The intermediate product of the semiconductor apparatus is heated at a temperature at which the sinterable particles can be sintered to each other, to cause at least a part of the organic binder to be burned out from the sinter bonding layer, while allowing the sinterable particles to be sintered to each other in the sinter bonding layer. Thereby, the plurality of semiconductor devices are respectively bonded to the semiconductor device mounting areas in the substrate. After these steps are performed, the plurality of semiconductor devices are respectively fixed to the semiconductor device mounting areas in the substrate by sintering the sinterable particles included in the divided sinter bonding layers. That is, a sintered body formed by sintering the sinterable particles allows the plurality of semiconductor devices to be fixed to the semiconductor device mounting areas of the substrate, respectively.

### SUMMARY OF THE INVENTION

### Technical Problem

In producing the semiconductor apparatus as aforementioned, it is preferable that the sinter bonding layer divided in the above steps (2) and (4) be transferred, while being sufficiently in tight contact with the semiconductor device. It is also preferable that, in producing the semiconductor apparatus as aforementioned, the semiconductor device in the above steps (3) and (4) be temporarily fixed in tight contact with the semiconductor device mounting area in the substrate by the sinter bonding layer. That is, it is preferable that the sufficient transfer properties of the sinter bonding layer to the semiconductor device and realizing the sufficient temporary fixing properties of the semiconductor device to the semiconductor device mounting area in the substrate via the sinter bonding layer be simultaneously realized in producing the semiconductor apparatus as aforementioned. Nevertheless, no sufficient consideration appears to have been made on simultaneously achieving both of the above two properties in producing the semiconductor apparatus as aforementioned.

It is therefore an object of the present invention to provide a sinter bonding sheet that can simultaneously realize both of the sufficient transfer properties of a sinter bonding layer to a semiconductor device and the sufficient temporary fixing properties of the semiconductor device to a semiconductor device mounting area in a substrate via the sinter bonding layer.

### Solution to Problem

The present inventors have diligently studied and finally found that both of the sufficient transfer properties of a sinter bonding layer to a semiconductor device and the sufficient temporary fixing properties of the semiconductor device to a semiconductor device mounting area in a substrate via the sinter bonding layer can be simultaneously realized by: configuring a sinter bonding sheet to have a sinter bonding layer including sinterable particles containing a conductive metal, and an organic binder; configuring the sinter bonding layer to have a first adhesive layer for being adhered to one adherend and a second adhesive surface for being adhered to another adherend; and configuring the sinter bonding layer such that, when the value of the minimum load reached during an unloading step in a load-displacement measurement according to the nanoindentation method to the first adhesive surface is b 1, and the value of the minimum load reached during the unloading step in the load-displacement measurement according to the nanoindentation method to the second adhesive surface 2b is b2, b 1 and b2 each fall under a certain numerical arrange. Thus, the present invention has been accomplished.

That is, the sinter bonding sheet according to the present invention includes a sinter bonding layer that includes sinterable particles containing a conductive metal, and an organic binder, in which the sinter bonding layer has a first adhesive surface for being adhered to an adherend and a second adhesive surface for being adhered to another adherend, and when the value of the minimum load reached during an unloading step in a load-displacement measurement according to the nanoindentation method to the first adhesive surface is b1, and the value of the minimum load reached during the unloading step in the load-displacement measurement according to the nanoindentation method to the second adhesive surface is b2, b 1 satisfies -100 µN≤b1≤-35 µN and b2 satisfies -100 µN≤b2≤-35 µN.

### BRIEF DESCRIPTION OF DRAWINGS

Fig. 1 is a cross-sectional view showing a configuration of a sinter bonding sheet according to an embodiment of the present invention.
Fig. 2 is cross-sectional view showing a configuration of the sinter bonding sheet according to another embodiment of the present invention.
Fig. 3A is a schematic sectional view showing a state where a first semiconductor chip is picked up from a dicing tape by a collet.
Fig. 3B is a schematic sectional view showing a state where a second semiconductor chip is picked up from the dicing tape by the collet.
Fig. 4Ais a schematic sectional view showing a state where a part of a sinter bonding layer of the sinter bonding sheet according to this embodiment is transferred to the first semiconductor chip.
Fig. 4B is a schematic sectional view showing a state where a part of the sinter bonding layer of the sinter bonding sheet according to this embodiment is transferred to the second semiconductor chip.
Fig. 5A is a schematic sectional view showing a state where the first semiconductor chip with a divided body of a sinter bonding layer is picked up by the collet.
Fig. 5B is a schematic sectional view showing a state where the second semiconductor chip with a divided body of the sinter bonding layer is picked up by the collet.
Fig. 6Ais a schematic sectional view showing a state where the first semiconductor chip with a divided body of the sinter bonding layer is temporarily fixed to a first die pad of a lead frame substrate.
Fig. 6B is a schematic sectional view showing a state where the second semiconductor chip with a divided body of the sinter bonding layer is temporarily fixed to a second die pad of the lead frame substrate.
Fig. 7A is a schematic sectional view showing an example of a state of heating the lead frame substrate, in which the first semiconductor chip is temporarily fixed to the first die pad via a divided body of the sinter bonding layer, and the second semiconductor ship is temporarily fixed to the second die pad via a divided body of the sinter bonding layer.
Fig. 7B is a schematic sectional view showing another example of a state of heating the lead frame substrate, in which the first semiconductor chip is temporarily fixed to the first die pad via a divided body of the sinter bonding layer, and the second semiconductor ship is temporarily fixed to the second die pad via a divided body of the sinter bonding layer segment.

### DETAILED DESCRIPTION OF THE PREFERRED EMBODIMENT

Hereinafter, a description will be given on one embodiment of the present invention. The one embodiment of the present invention herein may be simply referred to as this embodiment.

### (Sinter bonding sheet)

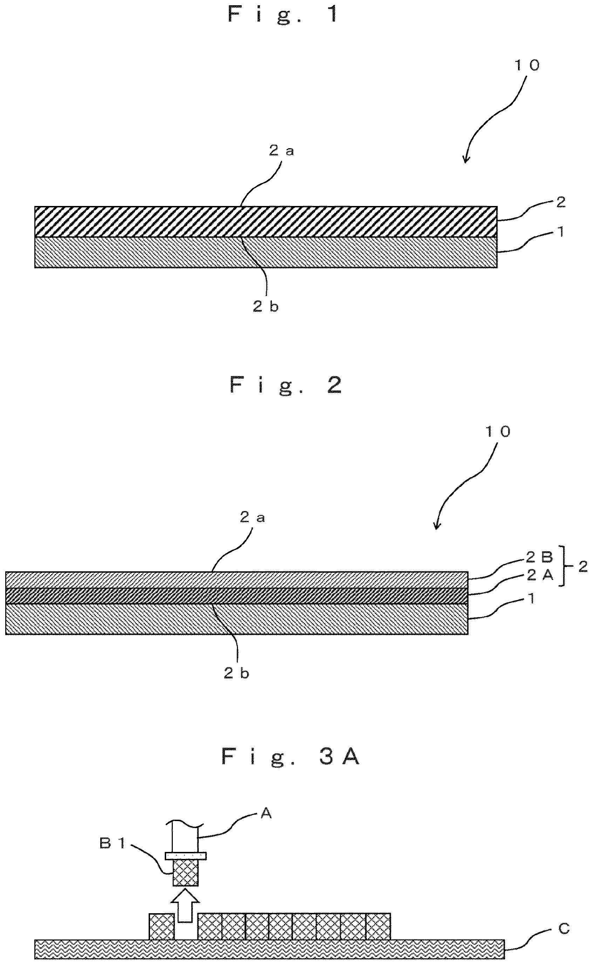

As shown in Fig. 1, a sinter bonding sheet 10 according to this embodiment includes a sinter bonding layer 2 that includes sinterable particles containing a conductive metal, and an organic binder. In an example shown in Fig. 1, the sinter bonding layer 2 is laminated on a substrate layer 1. The sinter bonding sheet 10 according to this embodiment has an elongated band-like shape and stored in a cylindrically-rolled state. In the sinter bonding sheet 10 according to this embodiment, the sinter bonding layer 2 has a first adhesive surface 2a for being adhered to one adherend and a second adhesive surface 2b for being adhered to another adherend. In the sinter bonding sheet 10 according to this embodiment, when the value of the minimum load reached during an unloading step in a load-displacement measurement according to the nanoindentation method to the first adhesive surface 2a is b1, and the value of the minimum load reached during the unloading step in the load-displacement measurement according to the nanoindentation method to the second adhesive surface 2b is b2, b1 satisfies -100 µN≤b1≤-35 µN and b2 satisfies -100 µN≤b2≤-35 µN. The conductive metal herein means a metal having an electric conductivity of 100 µS/cm or less measured according to JIS K 0130 (2008).

The sinter bonding layer 2 of the sinter bonding sheet 10 is, via an organic binder included in the sinter bonding layer 2, temporarily fixed to a substrate or transferred to a semiconductor chip. That is, the organic binder is left in the sinter bonding layer 2 when the sinter bonding layer 2 is temporarily fixed to the substrate or transferred to the semiconductor chip. On the other hand, the sinter bonding layer 2 plays a role to bond the semiconductor chip to the substrate by the sinterable particles included in the sinter bonding layer 2 sintered to each other. That is, in the state where the semiconductor chip is bonded to the substrate, at least part of the organic binder in the sinter bonding layer 2 is burned out. In terms of bonding the semiconductor chip to the substrate by sintering the sinterable particles to each other as described above, the residue of the organic binder in the sinter bonding layer 2 is preferably low as much as possible. That is, preferably almost no, more preferably no organic binder is left in the sinter bonding layer 2.

The value of the minimum load b1 reached during the unloading step in the load-displacement measurement according to the nanoindentation method to the first adhesive surface 2a and the value of the minimum load b2 reached during the unloading step in the load-displacement measurement according to the nanoindentation method to the second adhesive surface 2b can be obtained using, as a measuring device, a nanoindenter (for example, product name "Triboindenter" manufactured by Hysitron, Inc.). The load-displacement measurement according to the nanoindentation method using the nanoindenter can be performed in the following conditions.
· Indenter for use: Berkovich (trigonal pyramid) type diamond indenter (curvature radius: 10 nm to 100 nm)
· Measurement mode: Single indentation measurement
· Measurement temperature: Normal temperature (23 ± 2 °C)
· Indentation depth setting: 2 µm
· Maximum load (set value) reached during loading step (set value): 500 µN
· Indentation speed of indenter during loading step: 100 µN/sec
· Unloading speed of indenter during unloading step: 100 µN/sec
· Measurement sample: Sinter bonding layer 2 having a plane dimension of 10 mm square

The load-displacement measurement according to the nanoindentation method using the nanoindenter is performed by fixing the measurement sample onto a SUS plate (i.e., stainless steel plate) having a diameter of 15 mm, and thereafter fixing the SUS plate with the measurement sample fixed thereto onto a stage provided in the nanoindenter. The SUS plate with the measurement sample fixed thereto is fixed onto the stage by a magnet provided in the stage.

The lower the value of the value of the minimum load b 1 of the first adhesive surface 2a and the value of the minimum load b2 of the second adhesive surface 2b are, the higher the tackiness is. Also, the higher these values are, the lower the tackiness is. Therefore, when the value of the minimum b 1 and the value of the minimum load b2 are excessively low, a so-called "naki-wakare" (peeling off at an undesirable site) may occur in the sinter bonding layer 2 at the time of, for example, peeling the substrate layer 1 from the sinter bonding layer 2, although the adhesion of the sinter bonding layer 2 to an adherend such as a semiconductor chip or a substrate is improved. When the value of the value of the minimum load b1 and the value of the minimum load b2 are excessively high, the tackiness is reduced, which may prevent the sinter bonding layer 2 from being sufficiently adhered to an adherend such as a semiconductor chip or a substrate. Turning to the sinter bonding sheet 10 according to this embodiment, in which the value of the minimum load b 1 of the first adhesive surface 2a and the value of the minimum load b2 of the second adhesive surface 2b are appropriately adjusted, it is possible to realize the sufficient temporary fixing properties to the substrate, while realizing the sufficient transfer properties to the semiconductor chip.

The value of the minimum load b 1 of the first adhesive surface 2a and the value of the minimum load b2 of the second adhesive surface 2b can be adjusted by varying the content of the organic binder in the sinter bonding layer 2. The value of the minimum load b1 of the first adhesive surface 2a and the value of the minimum load b2 of the second adhesive surface 2b can be also adjusted by appropriately varying the degree of the release treatment of the substrate layer 1 to be laminated on the first adhesive surface 2a or the second adhesive surface 2b. For example, the value of the minimum load b1 of the first adhesive surface 2a and the value of the minimum load b2 of the second adhesive surface 2b can be lowered by subjecting the substrate layer 1 to the release treatment to enlarge the difference between a surface free energy of the sinter bonding layer 2 and a surface free energy of the substrate layer 1. Also, the value of the minimum load b1 and the value of the minimum load b2 can be adjusted by roughening a surface of the substrate layer 1 by, for example, embossing.

Examples of the conductive metal include gold, silver, copper, palladium, tin, and nickel. Also, the conductive metal can be an alloy of two or more metals selected from the group consisting of gold, silver, copper, palladium, tin, and nickel. Further, the conductive metal can be metal oxide such as silver oxide, copper oxide, palladium oxide, or tin oxide. In the sinter bonding sheet 10 according to this embodiment, the sinterable particles preferably contain, as the conductive metal, at least one selected from the group consisting of silver, copper, silver oxide, and copper oxide. The sinterable particles, which include as the conductive metal at least one selected from the group consisting of silver, copper, silver oxide, and copper oxide, can sufficiently improve, as described later, bonding properties by a divided sinter bonding layer 2 (i.e., divided body 2' of the sinter bonding layer) at the time of bonding a semiconductor device to a semiconductor device mounting area of the substrate via the divided sinter bonding layer 2 (i.e., divided body 2' of the sinter bonding layer). Further, the sinterable particles preferably contain silver or copper as the conductive metal in terms of imparting high conductivity and high heat dissipation to the sinter bonding layer 2. Considering the oxidation resistance, silver is preferably used as the conductive metal. For example, when coper is used as the conductive metal in bonding the semiconductor device such as a semiconductor chip to a die pad of a lead frame substrate by sintering the sinterable particles in the divided sinter bonding layer 2 (i.e., divided body 2' of the sinter bonding layer), the bonding needs to be performed under inert environment such as under nitrogen atmosphere. However, when silver is used as the conductive metal, the bonding can be favorably performed even under air atmosphere. The sinterable particles in the sinter bonding sheet 10 according to this embodiment can be particles having a core-shell structure formed by a core part and a shell part covering the core part. The conductive metal forming the core part can include copper as a main component, and the conductive metal forming the shell part can include gold or silver as a main component.

Examples of the shape of the sinterable particles include a flake shape, a needle shape, a filament shape, a spherical shape, and a flat shape (including a scale shape). Among them, the sinterable particles having a spherical shape are preferably used. The use of particles having a spherical shape as the sinterable particles can improve the dispersion properties of the sinterable particles in a varnish, to be described later, for obtaining the sinter bonding layer 2.

The sinterable particles can be sintered at a heating temperature of 400 °C or less. Capability of being sintered at a heating temperature of 400 °C or less herein mean that necking is observed on the outer surfaces of adjacent particles when heated at a temperature of 400 °C or less. The sintering temperature of the sinterable particles can be measured using a thermogravimetric analyzer. Specifically, measurement is performed using a thermogravimetric analyzer (TG8120, a differential thermogravimetry manufactured by Rigaku Corporation) in the following conditions to obtain a Tg curve and a DTA curve, and determine a largest peak temperature of the DTA curve which appears around the start point of the downward slope of the Tg curve. Thereby, the sintering temperature of the sinterable particles can be obtained.

### <Measurement conditions>

· Temperature rising rate: 10 °C/min
· Measurement atmosphere: Air atmosphere
· Measurement temperature range: Room temperature (23 ± 2 °C) to 500 °C

The sinterable particles including, as the conductive metal, gold, silver, copper, palladium, tin, or nickel and an alloy of these metals can be sintered by heating at a temperature of 400 °C or less.

An average particle size of the sinterable particles is preferably 1 nm or more, more preferably 10 nm or more, further preferably 50 nm or more. The average particle size of the sinterable particles equal to or more than the above lower limit can improve dispersion properties of the sinterable particles in a varnish, to be described later, for obtaining the sinter bonding layer 2. In the sinter bonding layer 2 obtained in this way, the sinterable particles are favorably dispersed. The average particle size of the sinterable particles is preferably 10000 nm or less, more preferably 3000 nm or less, further preferably 1000 nm or less, still further preferably 500 nm or less. The average particle size of the sinterable particles equal to or less than the above upper limit can allow the sinter bonding layer 2 to have a relatively smooth surface. The average particle size of the sinterable particles can be determined by observing the cross section of the sinter bonding layer 2 using a scanning electron microscope (SEM). Specifically, the determination can be made with the following steps.
(1) A sinter bonding layer 2 having a plane dimension of 10 mm × 10 mm and a thickness of 50 µm (i.e., 0.05 mm) is prepared.
(2) The sinter bonding layer 2 and a chip having a second electrode (plane dimension: 10 mm× 10 mm, thickness: 3 mm) are disposed in this order on a substrate (plane dimension: 10 mm× 10 mm, thickness: 3 mm) having a first electrode on one surface to obtain a laminated body, followed by subjecting the laminated body to a sintering treatment to obtain a sinter bonding body. The sintering treatment is performed in the conditions of heating under a pressure of 10 MPa from 80 °C to 300°C at a temperature rising rate of 1.5 °C/sec, and then maintaining at 300 °C for 2.5 minutes. The sinter bonding layer 2 is disposed on the substrate to be in abutting contact with the first electrode, and the chip is disposed to have the second electrode in abutting contact with an exposed surface of the sinter bonding layer 2.
(3) An entire outer surface of the sinter bonding body is embedded in an embedding resin (for use in SEM), and then the outer surface of the embedded sinter bonding body is adjusted by polishing.
(4) The surface-adjusted sinter bonding body is cut along a thickness direction using a milling apparatus to obtain a sample for SEM observation.
(5) While the cutting surface of the sample for SEM observation is observed using a SEM, an image of the cutting surface is captured to obtain an average particle size of the sinterable particles by analyzing the captured image. The image capturing is performed in the conditions at an accelerating voltage of 3 kV. The image analysis is performed using a SEM image magnified by 10,000 times or 100,000 times based on the size of the sinterable particles. The image analysis can be performed by subjecting the captured image to a binarization processing, to allow each of the sinterable particles included in the cutting surface to be identified. Then, a circle equivalent diameter of each of the sinterable particles included in the cutting surface is calculated, followed by arithmetically averaging the calculated values of the obtained circle equivalent diameter. Thereby, the average particle size of the sinterable particles can be determined. The sinterable particles of which an entire outline do not appear in the cutting surface are excluded from the subject for calculation of the circle equivalent diameter. The circle equivalent diameter herein means a diameter that can be obtained by calculating an area of a sinterable particle in the cutting surface, and then converting the calculated area into a diameter of a true circle having an area corresponding to the calculated area.

When the conductive metal is silver, that is, when the sinterable particles are silver particles, the silver particles can be silver particles composed of a silver element and another element included as an inevitable impurity element (e.g., metal element), or can be silver particles subjected to a surface treatment (e.g., silane coupling treatment). Examples of a surface treatment agent for the silver particles include a coating agent that is aliphatic acid-based, amine-based, or epoxy-based. The silver particles subjected to surface treatment with an aliphatic acid-based, amine-based, or epoxy-based coating agent may be hereinafter referred to as the silver particles treated with a coating agent. The use of the silver particles treated with a coating agent as the sinterable particles can increase affinity between the organic binder and the sinterable particles in the sinter bonding layer 2 before at least part of the organic binder is burned out by a heating treatment in, for example, the production of a semiconductor apparatus to be described later. Thereby, the sinterable metal particles become more easily dispersed in the sinter bonding layer 2 before at least part of the organic binder is burned out. At least part of the organic binder is burned out from the sinter bonding layer 2 by heating the sinter bonding layer 2 at a certain temperature or more as described in the production of a semiconductor apparatus to be described later.

In the sinter bonding sheet 10 according to this embodiment, the content percentage (SC) of the sinterable particles in the sinter bonding layer 2 is preferably 60 mass% or more, more preferably 65 mass% or more, further preferably 70 mass% or more, still further preferably 85 mass% or more. The content percentage (SC) of the sinterable particles in the sinter bonding layer 2 is preferably 99 mass% or less, more preferably 98 mass% or less, further preferably 97 mass% or less. The content percentage (SC) of the sinterable particles within the above numerical range allows the sinterable particles to be sintered to each other in the sinter bonding layer 2, thereby enabling highly reliable bonding when a semiconductor device such as a semiconductor chip is bonded to a die pad of a lead frame substrate.

The content percentage (SC) of the sinterable particles in the sinter bonding layer 2 can be determined from the amount of ash left after burning the sinter bonding layer 2. The content percentage (SC) of the sinterable particles can be measured using, for example, a thermogravimetric analyzer (e.g., TG209F1). The measurement using the thermogravimetric analyzer can be performed with the following steps.
(1) Using about 50 mg of the sinter bonding layer 2 as a measurement sample, the measurement sample is heated from room temperature (23 ± 2 °C) to 650 °C.
(2) The organic binder in the sinter bonding layer 2 is maintained at 650 °C for 30 minutes to be thereby thermally degraded.
(3) The ratio of the mass of the remaining component (ash) to the mass (about 50 mg) of the measurement sample before the heat treatment is determined.

The measurement using the thermogravimetric analyzer can be performed under an atmospheric air flow or can be performed under a nitrogen gas flow. Since the copper particles are susceptible to oxidization in the aforementioned temperature at the time of analysis, the measurement using the thermogravimetric analyzer is preferably performed under the nitrogen gas flow when the sinter bonding layer 2 includes the copper particles as the sinterable particles.

In the sinter bonding sheet 10 according to this embodiment, the sinter bonding layer 2 preferably includes, as the organic binder, a first organic binder and a second organic binder having a molecular weight smaller than that of the first organic binder.

The first organic binder is preferably a thermally-degradable high molecular binder. The thermally-degradable high molecular binder is a binder thermally degraded during a high-temperature heating step for forming sintered bonds by sintering the sinterable particles. The thermally-degradable high molecular binder contributes to, before the high-temperature heating step, keep the sinter bonding layer 2 in a sheet shape. In terms of securing the function of keeping the sinter bonding layer 2 in a sheet shape, the thermally-degradable high molecular binder is preferably a solid material at room temperature (23 ± 2 °C). Examples of the thermally-degradable high molecular binder include a polycarbonate resin and an acrylic resin. That is, the sinter bonding layer 2 preferably includes at least one of the polycarbonate resin and the acrylic resin as the first organic binder. The sinter bonding layer 2 can include only the polycarbonate resin as the first organic binder.

Examples of the polycarbonate resin include an aliphatic polycarbonate composed of an aliphatic chain with no aromatic compound such as a benzene ring between the carbonate esters (-O-C-O-O-) of the main chain, and an aromatic polycarbonate having the aromatic compound between the carbonate esters (-O-C-O-O-) of the main chain. Examples of the aliphatic polycarbonate include polyethylene carbonate and polypropyrene carbonate. Examples of the aromatic polycarbonate include polycarbonate having a bisphenol-A structure in the main chain.

Examples of the acrylic resin include at least one of an acrylate ester polymer and a methacrylate ester polymer, having a linear or branched 4-18C alkyl group. Hereinafter, "(meth)acrylic" means at least one of "acrylic" and "methacrylic", and "(meth)acrylate" means at least one of "acrylate" and "methacrylate". Examples of the alkyl group of a (meth)acrylate ester for forming an acrylic resin as the thermally-degradable high molecular binder include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, and an octadecyl group.

The acrylic resin can be a polymer including a monomer unit derived from a monomer other than the (meth)acrylate ester. Examples of the other monomer include a carboxy group-containing monomer, an acid anhydride monomer, a hydroxy group-containing monomer, a sulfonic acid group-containing monomer, and a phosphate group-containing monomer. Examples of the carboxy group-containing monomer include acrylic acid, methacrylic acid, carboxyethyl acrylate, carboxypentyl acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylic acid, 2-hydroxypropyl (meth)acrylic acid, 4-hydroxybutyl (meth)acrylic acid, 6-hydroxyhexyl (meth)acrylic acid, 8-hydroxyoctyl (meth)acrylic acid, 10-hydroxydecyl (meth)acrylic acid, 12-hydroxylauryl (meth)acrylic acid, and 4-(hydroxymethyl) cyclohexylmethyl (meth)acrylic acid. Examples of the sulfonic acid group-containing monomer include styrenesulfonic acid, arylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid. Examples of the phosphate group-containing monomer include 2-hydroxyethyl acryloyl phosphate.

A volume-average molecular weight of the first organic binder is preferably 10000 or more. The volume-average molecular weight of the first organic binder is a value measured by a gel permeation chromatography (GPC) and converted in terms of polystyrene.

The second organic binder is preferably a low boiling point binder. The low boiling point binder is a binder component having a boiling point lower than the initial temperature of thermal decomposition of the thermally-degradable high molecular binder. In this embodiment, the low boiling point binder is a substance having a viscosity of 1 × 105 Pa s at 23 °C when measured using a dynamic viscoelasticity measurement instrument (product name "HAAKE MARS III" manufactured by Thermo Fisher Scientific), and is a liquid substance or a semiliquid substance. The viscosity measurement herein is performed by using parallel plates having a diameter of 20 mm as a jig, setting a gap between the plates at 100 µm, and setting a shear rate in rotary shearing at 1s⁻¹.

Examples of the low boiling point binder include terpene alcohols, alcohols other than terpene alcohols, alkylene glycol alkyl ethers, and ethers other than alkylene glycol alkyl ethers. Examples of the terpene alcohols include isobornyl cyclohexanol, citronellol, geraniol, nerol, carveol, and α-terpineol. Examples of the alcohols other than the terpene alcohols include pentanol, hexanol, heptanol, octanol, 1-decanol, ethylene glycol, diethylene glycol, propylene glycol, butylene glycol, and 2,4-diethyl-1,5-pentanediol. Examples of the alkylene glycol alkyl ethers include ethylene glycol butyl ether, diethylene glycol methyl ether, diethylene glycol ethyl ether, diethylene glycol butyl ether, diethylene glycol isobutyl ether, diethylene glycol hexyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol methyl ether, triethylene glycol dimethyl ether, triethylene glycol butyl methyl ether, propylene glycol propyl ether, dipropylene glycol methyl ether, dipropylene glycol ethyl methyl ether, dipropylene glycol propyl ether, dipropylene glycol butyl ether, and tripropylene glycol dimethyl ether. Examples of the ethers other than the alkylene glycol alkyl ethers include ethylene glycol ethyl ether acetate, ethylene glycol butyl ethyl acetate, diethylene glycol ethyl ether acetate, diethylene glycol butyl ethyl acetate, and dipropylene glycol methyl ether acetate. One of the low boiling point binders can be used individually, or two or more of them can be used in combination. As the low boiling point binder, the terpene alcohols are preferably used in terms of the stability at room temperature. Among the terpene alcohols, isobornyl cyclohexanol described above is preferably used.

Isobornyl cyclohexanol described above is a compound represented by formula (1) below. Isobornyl cyclohexanol described above is an organic compound having a boiling point of 308 °C to 318 °C, and has characteristics that, when heated under a nitrogen gas flow of 200 mL/min from room temperature (23 ± 2 °C) to 600 °C at a temperature rising rate of 10 °C/min, mass reduction becomes significant when the temperature reaches 100 °C and such significant mass reduction continues as the temperature increases, and volatilization and vanishment occurs (i.e., no further weight reduction is found) at 245 °C. Isobornyl cyclohexanol has further characteristics that it has an extremely high viscosity of 1,000,000 Pa s at 25 °C but has a relatively low viscosity of 1000 mPa s or less at 60 °C. The mass reduction refers to a value obtained when the mass reduction ratio at a measurement starting temperature (room temperature) is 0 %. Isobornyl cyclohexanol exhibits an extremely high viscosity at 25 °C as described above and thus can keep the thermosetting sheet in a sheet shape at room temperature. On the other hand, isobornyl cyclohexanol exhibits a relatively low viscosity at 60 °C as described above and thus has tackiness. That is, the sinter bonding sheet 10 having the sinter bonding layer 2 including isobornyl cyclohexanol is excellent in capability of keeping itself in a sheet shape at room temperature, and has tackiness at 60 °C and higher. When a semiconductor device bonded to one side of the sinter bonding layer 2 is mounted on a lead frame substrate or the like, it is general that the semiconductor device is temporarily attached (fixed) to an adherend such as the lead frame substrate or the like via the sinter bonding layer 2 at a temperature of 60 to 80 °C. Here, isobornyl cyclohexanol has tackiness at 60 °C and higher as described above. Thus, in the case where the sinter bonding layer 2 in the sinter bonding sheet 10 according to this embodiment includes isobornyl cyclohexanol as the second organic binder, the capability of the sinter bonding layer 2 to an adherend such as a lead frame substrate is further improved. That is, the sinter bonding layer 2 in the temporarily fixed state suppresses the semiconductor device from being displaced from its mounting position, and is suppressed from rising from the adherend.

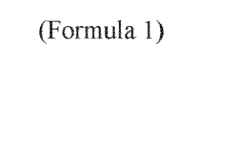

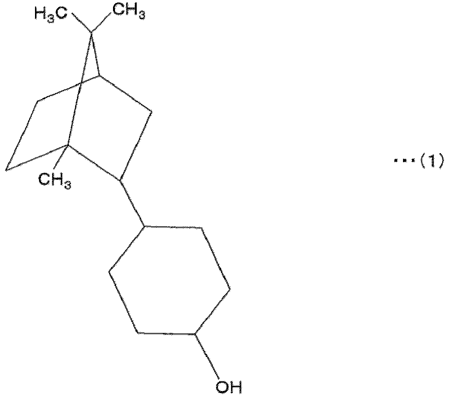

In the case where the sinter bonding layer 2 includes, as the organic binder, the first organic binder and the second organic binder having a molecular weight smaller than that of the first organic binder, BC₁ and BC₂ preferably satisfy the relationship of BC₁:BC₂ = 6:4 to 0.5:9.5, more preferably satisfy the relationship of BC₁:BC₂ = 5:5 to 1:9, further preferably satisfy the relationship of BC₁:BC₂ = 4:6 to 2:8, in which BC₁ mass% represents the content percentage of the first organic binder, and BC₂ mass% represents the content percentage of the second organic binder.

The content percentage BC₁ of the first organic binder is preferably 0.01 mass% or more, more preferably 0.05 mass% or more, further preferably 0.10 mass% or more, still further preferably 0.20 mass% or more. The content percentage BC₁ of the first organic binder is preferably 20 mass% or less, more preferably 10 mass% or less, further preferably 7.5 mass% or less, still further preferably 5.0 mass% or less.

The content percentage BC₂ of the second organic binder is preferably 0.5 mass% or more, more preferably 1.0 mass% or more, further preferably 1.5 mass% or more, still further preferably 2.0 mass% or more. The content percentage BC₂ of the second organic binder is preferably 20 mass% or less, more preferably 15 mass% or less, further preferably 10 mass% or less.

The value of the minimum load b1 for the first adhesive surface 2a preferably satisfies -100 µN≤b1≤-45 µN, more preferably satisfies -95 µN≤b1≤-50 µN, further preferably satisfies -90 µN≤b1≤-55 µN. The value of the minimum load b2 for the second adhesive surface 2b preferably satisfies -90 µN<b2≤-39 µN, more preferably satisfies -85 µN≤b2≤-45 µN.

The b1 and the b2 preferably satisfy b1≤ b2. The value of the b2 is preferably 1.00 times or more, more preferably 1.05 times or more, further preferably 1.10 times or more of the b1. The value of the b2 is preferably 2.00 times or less, more preferably 1.50 times or less, further preferably 1.20 times or less of the b1.

As shown in Fig. 2, the sinter bonding layer 2 can include a first sinter bonding layer 2A and a second sinter bonding layer 2B laminated on the first sinter bonding layer 2A. That is, the sinter bonding layer 2 can be a laminated body in which two or more sinter bonding layers are laminated on each other. When the sinter bonding layer 2 is a laminated body as shown in Fig. 2, the first sinter bonding layer 2A and the second sinter bonding layer 2B are preferably different from each other in the content percentage BC₁ of the first organic binder, different from each other in the content percentage BC₂ of the second organic binder, or different from each other in the content percentage (SC) of the sinterable particles. The first sinter bonding layer 2A and the second sinter bonding layer 2B can have the same composition. That is, the first sinter bonding layer 2A and the second sinter bonding layer 2B can have, for example, the same content percentage BC₁ of the first organic binder, the same content percentage BC₂ of the second organic binder, and the same content percentage (SC) of the sinterable particles.

In the sinter bonding sheet 10 according to this embodiment, a thickness of the sinter bonding layer 2 is preferably 5 µm or more, more preferably 10 µm or more. In the sinter bonding sheet 10 according to this embodiment, the thickness of the sinter bonding layer 2 is preferably 300 µm or less, more preferably 150 µm or less. The thickness of the sinter bonding layer 2 can be obtained by, for example, measuring the thickness thereof at any 5 positions selected at random using a dial gauge (model R-205 manufactured by PEACOCK), followed by arithmetically averaging these thickness values.

The sinter bonding layer 2 can be produced by, for example, allowing the sinterable particles and the organic binder to be dissolved or suspended in an organic solvent to prepare a varnish, applying the varnish on the substrate layer 1 to form a coating film having a certain thickness, and then drying the coating film. As the organic solvent to prepare the varnish, for example, alcohols such as ethanol, or ketones such as methyl ethyl ketone (MEK) can be used.

The substrate layer 1 functions as a support body in the sinter bonding sheet 10. The substrate layer 1 is made of, for example, a plastic base material. A plastic film is preferably used as the plastic base material. Examples of constituent materials of the plastic base material include a polyolefin resin, a polyester resin, a polyurethane resin, a polycarbonate resin, a polyetheretherketone resin, a polyimide resin, a polyetherimide resin, a polyamide resin, a wholly aromatic polyamide resin, a polyvinyl chloride resin, a polyvinylidene chloride resin, a polyphenyl sulfide resin, an aramid resin, a fluorine resin, a cellulose-based resin, and a silicone resin. Examples of the polyolefin resin include a low density polyethylene resin, a linear low density polyethylene resin, a medium density polyethylene resin, a high density polyethylene resin, a very low density polyethylene resin, a random copolymer polypropylene resin, a block copolymer polypropylene resin, a homo polypropylene resin, a polybutene resin, a polymethylpentene resin, an ethylene-vinyl acetate copolymer resin, an ionomer resin, an ethylene-butene copolymer resin, and an ethylene-hexene copolymer resin. Examples of the polyester resin include a polyethylene terephthalate resin, a polyethylene naphthalate resin, and a polybutylene terephthalate resin. The substrate layer 1 can be composed of a single constituent material or can be composed of two or more constituent materials. The substrate layer 1 can have a single layer structure or can have a multilayer structure. The single layer structure means a structure composed of one constituent material. For example, a structure in which two or more layers composed of one constituent material are laminated on each other is categorized as a single layer structure. On the other hand, the multilayer structure means a structure in which two or more layers respectively composed of different constituent materials are laminated on each other. When the substrate layer 1 is made of a plastic film, the substrate layer 1 can be formed by a non-stretched film or can be formed by a stretched film. The stretched film can be a uniaxially stretched film or can be a biaxially stretched film. When the semiconductor apparatus is produced using the sinter bonding sheet 10 as described later, the substrate layer 1 can function as a release liner that allows a divided body of the sinter bonding layer 2 (i.e., divided body 2' of the sinter bonding layer) to be easily peeled off. In the case where the substrate layer 1 functions as a release liner, a remover can be applied to the substrate layer 1 on a surface in contact with the sinter bonding layer 2.

The thickness of the substrate layer 1 is preferably 10 µm or more, more preferably 20 µm or more, further preferably 30 µm or more. The thickness of the substrate layer 1 is preferably 5000 µm or less, more preferably 4000 µm or less, further preferably 3000 µm or less. The thickness of the substrate layer 1 can be obtained by, for example, measuring the thickness thereof at any 5 positions selected at random using a dial gauge (model R-205 manufactured by PEACOCK), followed by arithmetically averaging these thickness values.

### (Method for producing a semiconductor apparatus)

Next, a description will be given on an example of a method for producing a semiconductor apparatus using the sinter bonding sheet 10 according to this embodiment, with reference to Fig. 3A to Fig. 7B.

The method for producing a semiconductor apparatus according to this embodiment is performed using a plurality of semiconductor chips, a substrate including a plurality of mounting areas on which the plurality of semiconductor chips are respectively mounted, the sinter bonding sheet 10 according to this embodiment, and a first pressing member configured to press the semiconductor chips to the substrate with a part of the sinter bonding layer 2 of the sinter bonding sheet 10 interposed therebetween to allow the plurality of semiconductor chips to be bonded to the plurality of mounting areas. In the method for producing a semiconductor apparatus according to this embodiment, the plurality of semiconductor chips are pressed in order by the first pressing member to be temporarily fixed to the plurality of mounting areas, respectively.

Hereinafter, a description will be given on a case where the substrate is a lead frame substrate, the mounting area is a die pad, and the first pressing member is a collet.

First, a semiconductor wafer is cut on a dicing tape C to obtain a plurality of semiconductor chips (see Fig. 3A). Next, as shown in Fig. 3A, one semiconductor chip B1 (hereinafter also referred to as the first semiconductor chip B1) out of the plurality of semiconductor chips is picked up by a collet A from the dicing tape C. In general, the semiconductor chip has a rectangular plate shape. More specifically, the semiconductor chip has a square plate shape. A thickness of the semiconductor chip is, for example, 10 µm or more and 500 µm or less. The thickness of the semiconductor chip is preferably 20 µm or more and 400 µm or less. An area of the semiconductor chip in plan view is, for example, 0.01 mm² or more and 1000 mm² or less. The area of the semiconductor chip in plan view is preferably 0.04 mm² or more and 500 mm² or less. A plane dimension of the collet A on the side in contact with the semiconductor chip corresponds to the dimension of the chip size. That is, an area S1 (hereinafter also referred to as the collet area S1) of the collet A on the side in contact with the semiconductor chip corresponds in plan view to an area S2 (hereinafter also referred to as the chip area S2) of the semiconductor chip in plan view. More specifically, the collet area S1 is 0.9 times or more and 1.1 times or less as large as the chip area S2.

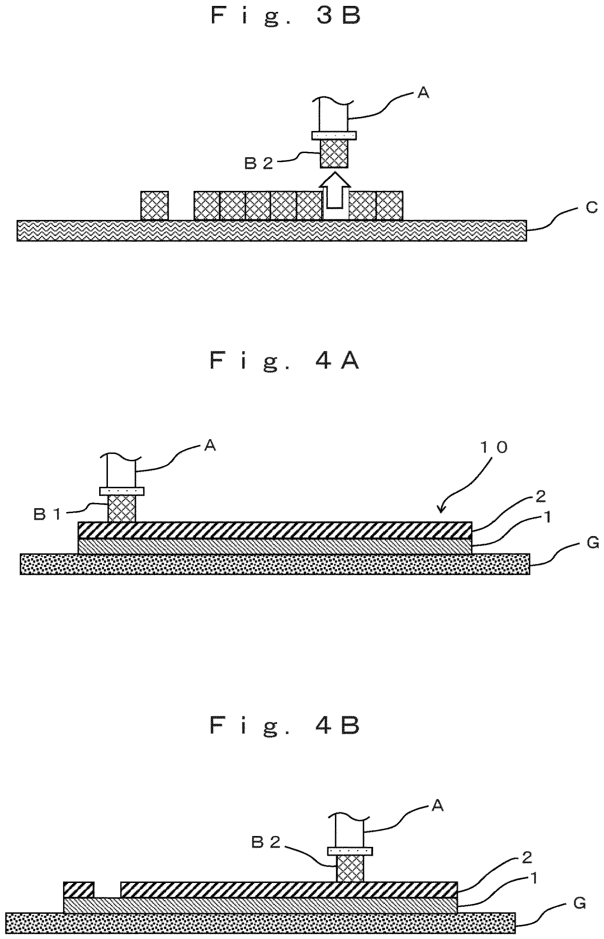

Next, as shown in Fig. 4A, the sinter bonding sheet 10 is mounted on a stage G with the sinter bonding layer 2 placed on the upper side in the sinter bonding sheet 10. Then, the first semiconductor chip B1 is pressed onto the sinter bonding layer 2 in the sinter bonding sheet 10 by the collet A to transfer a part of the sinter bonding layer 2 to the first semiconductor chip B1. Thereby, the first semiconductor chip B1 with the divided body of the sinter bonding layer 2 (hereinafter also referred to as the divided body 2' of the sinter bonding layer') can be obtained. The pressure for pressing the first semiconductor chip B1 onto the sinter bonding layer 2 is preferably 0.01 MPa or more and 10 MPa or less, more preferably 0.1 MPa or more and 5 MPa or less. The temperature of the collet A or the stage G when the first semiconductor chip B1 is pressed onto the sinter bonding layer 2 is preferably 40 °C or more and 150 °C or less, more preferably 50 °C or more and 130 °C or less. The temperature of the collet A or the stage G within the above range allows the divided body 2' of the sinter bonding layer to be appropriately transferred to the first semiconductor chip B1.

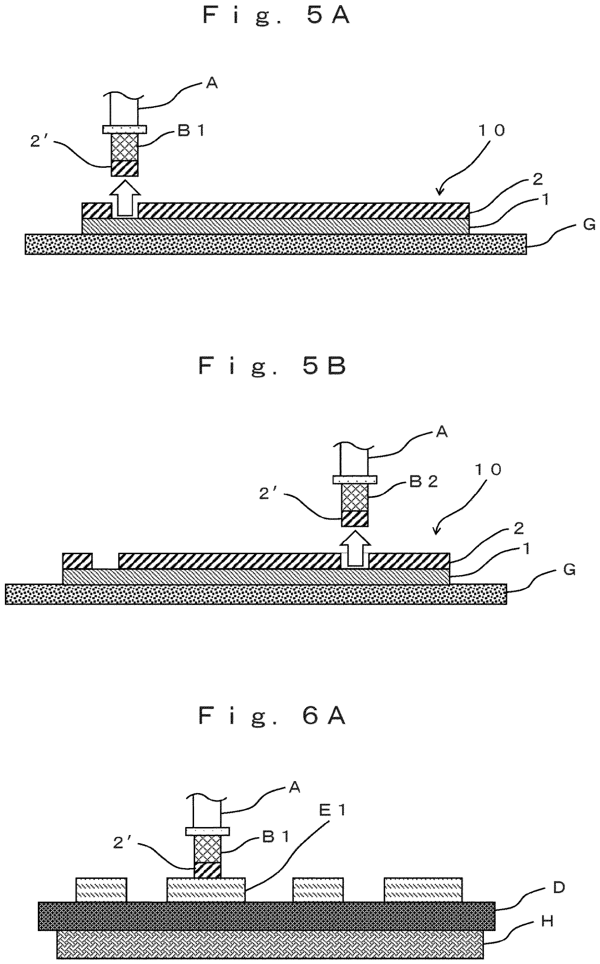

Next, as shown in Fig. 5A, the first semiconductor chip B1 with the divided body 2' of the sinter bonding layer is picked up from the sinter bonding sheet 10 by the collet A.

Next, as shown in Fig. 6A, a lead frame substrate D is mounted on a stage H. The collet A that is kept at a temperature in the range between 25 °C and 100 °C is moved vertically downward to allow the divided body 2' of the sinter bonding layer in the first semiconductor chip B1 to come into contact with a first die pad E1 in the lead frame substrate D. Then, the first semiconductor chip B1 with the divided body 2' of the sinter bonding layer is pressed (i.e., applied with pressure) by the collet A. Specifically, pressure is applied to the first semiconductor chip B1 by the collet A to attach the divided body 2' of the sinter bonding layer to the first die pad E1 of the lead frame substrate D. Thereby, the first semiconductor chip B1 is temporarily fixed to the first die pad E1 of the lead frame substrate D via the divided body 2' of the sinter bonding layer (see Fig. 6A). The pressure when the first semiconductor chip B1 with the divided body 2' of the sinter bonding layer is pressed onto the first die pad E1 of the lead frame substrate D from the side of the divided body 2' of the sinter bonding layer is preferably 0.01 MPa or more and 50 MPa or less, more preferably 0.1 MPa or more and 30 MPa or less.

After the first semiconductor chip B1 is temporarily fixed to the first die pad E1 of the lead frame substrate D as described above, another semiconductor chip B2 (hereinafter also referred to as the second semiconductor chip B2) out of the plurality of semiconductor chips is picked up from the dicing tape C by the collet A as shown in Fig. 3B.

Next, as shown in Fig. 4B, the second semiconductor chip B2 is pressed onto the sinter bonding layer 2 of the sinter bonding sheet 10 by the collet A to transfer a part of the sinter bonding layer 2 to the second semiconductor chip B2. Thereby, the second semiconductor chip B2 with the divided body 2' of the sinter bonding layer can be obtained.

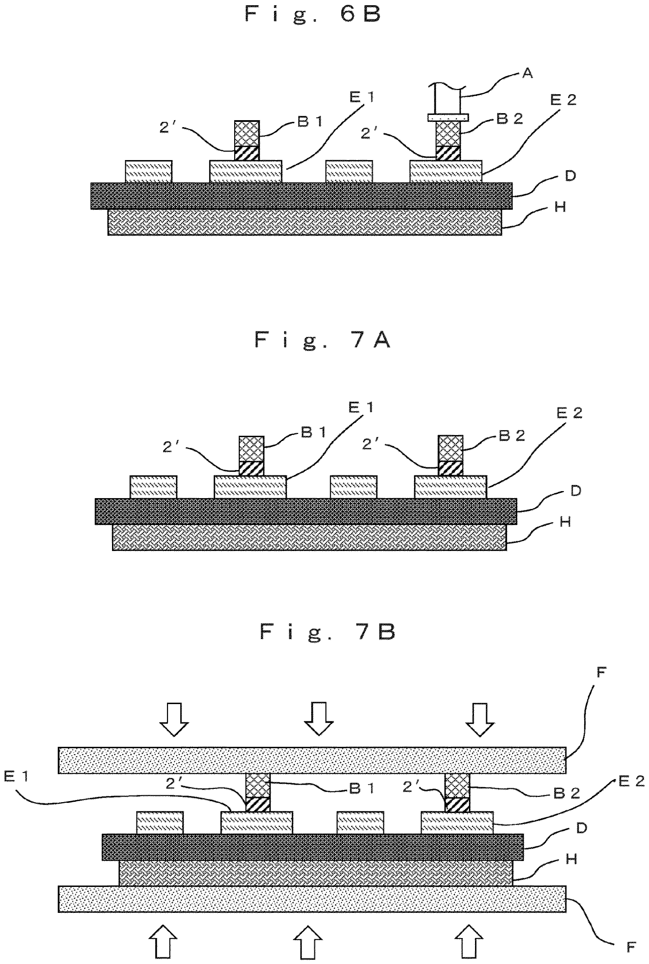

Next, as shown in Fig. 5B, the second semiconductor chip B2 with the divided body 2' of the sinter bonding layer is picked up from the sinter bonding sheet 10 by the collet A. Next, with the collet A kept at a temperature in the range between 25 °C and 150 °C, the second semiconductor chip B2 with the divided body 2' of the sinter bonding layer is allowed to come into contact with the other die pad E2 (i.e., second die pad E2) in the lead frame substrate D from the side of the divided body 2' of the sinter bonding layer. Then, the second semiconductor chip B2 with the divided body 2' of the sinter bonding layer is pressed (i.e., applied with pressure) by the collet A. Thereby, the second semiconductor chip B2 is temporarily fixed to the second die pad E2 of the lead frame substrate D via the divided body 2' of the sinter bonding layer (see Fig. 6B). The aforementioned steps are subsequently repeated until the semiconductor chips are respectively mounted on all of the die pads of the lead frame substrate D.

After, for example, the first semiconductor chip B1 is temporarily fixed to the first die pad E1 of the lead frame substrate D or the second semiconductor chip B2 is temporarily fixed to the second die pad E2 of the lead frame substrate D, it can be configured such that the collet A is heated to a temperature at which the sinterable metal particles (i.e., the sinterable metal particles included in the divided body 2' of the sinter bonding layer) can be sintered, and thereby the sinterable metal particles in the divided body 2' of the sinter bonding layer are subjected to a primary sintering. That is, when there is a semiconductor chip in addition to the first semiconductor chip B1 and the second semiconductor chip B2 as the semiconductor chip to be temporarily fixed to the die pad of the lead frame substrate D, the primary sintering can be performed on the sinterable particles included in the divided body 2' of the sinter bonding layer used for temporarily fixing the other semiconductor chip to the die pad.

When the sinterable particles included in the divided body 2' of the sinter bonding layer are sinterable particles that can be sintered at a heating temperature of 400 °C or less, the collet A is preferably heated at a temperature of 200 °C or more. Since the collet A heated to a temperature of 200 °C or more allows the sinterable particles to be more sufficiently sintered to each other, the semiconductor chips can be more firmly mounted on the die pads of the lead frame substrate D. That is, the connection reliability of a semiconductor chip such as the first semiconductor chip B1 or the second semiconductor chip B2 to a substrate such as the lead frame substrate D can be improved.

When the primary sintering is performed, it is preferable that the collet A be rapidly heated (in about 5 seconds) to a temperature at which the sinterable particles can be sintered. The collet A is heated to a temperature at which the sinterable particles can be sintered at a heating rate of preferably 30 °C/sec or more, more preferably 45 °C/sec or more. The primary sintering can be performed by heating the stage H, in addition to heating of the collet A, to a temperature equal to or higher than the temperature at which the sinterable particles can be sintered. Thereby, the heating can be performed from both sides of the divided body 2' of the sinter bonding layer so that the sinterable particles can be further sufficiently sintered to each other in the divided body 2' of the sinter bonding layer. As a result, the semiconductor chips can be further firmly mounted on the die pads of the lead frame substrate D with the divided body 2' of the sinter bonding layer interposed therebetween. That is, the connection reliability of a semiconductor chip such as the first semiconductor chip B1 or the second semiconductor chip B2 to a substrate such as the lead frame substrate D can be further improved. The temperature for heating the stage H is preferably equal to or lower than the temperature at which the lead frame substrate D is suppressed from being oxidized. For example, in the case where the lead frame substrate D is composed of a Cu alloy (e.g., Cu-Cr-Zr, Cu-Cr-Sn-Zn, and Cu-Ni-Si-Mg), the temperature for heating the stage H is preferably 150 °C or less.

After the first sintering is performed on the divided body 2' of the sinter bonding layer, it is preferable that the collet A be pulled upward to be separated from the semiconductor chip with the divided body 2' of the sinter bonding layer to lower the temperature of the collet A to a temperature at which the sinterable particles are barely sintered (for example, 50 °C).

When the primary sintering is performed on each of the divided bodies 2' of the sinter bonding layer at the time of mounting the semiconductor chips to all of the die pads of the lead frame substrate D, a bonding wire can be applied to a required part.

In the method for producing the semiconductor apparatus according to this embodiment, as described above, a part of the sinter bonding layer 2 of the sinter bonding sheet 10 according to this embodiment is transferred to one adherend such as a semiconductor chip, and the semiconductor chip is temporarily fixed to the die pad of the lead frame substrate via the part of the sinter bonding layer 2. Further, in the sinter bonding layer 2 of the sinter bonding sheet 10 according to this embodiment, when the value of the minimum load reached during an unloading step in a load-displacement measurement according to the nanoindentation method to the first adhesive surface 2a is b 1, and the value of the minimum load reached during the unloading step in the load-displacement measurement according to the nanoindentation method to the second adhesive surface 2b is b2, b1 satisfies -100 µN≤b1≤-35 µN and b2 satisfies -100 µN≤b2≤-35 µN. That is, the first adhesive surface 2a and the second adhesive surface 2b each have an appropriate tackiness. Hence, in addition to realizing sufficient transfer properties of the sinter bonding layer 2 to the semiconductor chip, the method for producing a semiconductor apparatus according to this embodiment can realize sufficient temporary fixing properties of the semiconductor chip to the semiconductor chip mounting area such as the die pad via the sinter bonding layer 2.

The method for producing a semiconductor apparatus according to this embodiment can include, after the plurality of semiconductor chips are pressed in order to be temporarily fixed to the plurality of mounting areas, a heating step of heating the substrate with the plurality of semiconductor chips mounted thereon at a temperature at which the sinterable particles can be sintered. In the aforementioned heating step, the aforementioned heating can be performed, while pressing only the part or all of the plurality of semiconductor chips onto the substrate. In the aforementioned heating step, the pressing can be performed, while pressing none of the plurality of semiconductor chips onto the substrate. The aforementioned heating step is provided as a secondary heating step when heating (i.e., primary heating) is performed in order to primarily sintering the sinterable particles included in the divided body 2' of the sinter bonding layer.

More specifically, it can be configured such that the stage H is heated (i.e., the heating step is performed) to the temperature (for example, any temperature within the range between 200 °C and 400 °C) at which the sinterable particles included in the divided body 2' of the sinter bonding layer can be sintered, in the state where, as shown in Fig. 7A, a part or all of the semiconductor chips mounted on all of the die pads of the lead frame substrate D are not being pressed after the semiconductor chips are temporarily fixed to all of the die pads of the lead frame substrate D. Fig. 7A shows an example of a heating operation which is performed while pressing none of the semiconductor chips (i.e., the first semiconductor chip B1 and the second semiconductor chip B2) mounted on all of the die pads (i.e., the first die pad E1 and the second die pad E2) of the lead frame substrate D. With the heating step performed in this way, the sinterable particles can be sintered to each other, and thus the semiconductor chips can be firmly mounted on the substrate (i.e., lead frame substrate D) with the divided bodies 2' of the sinter bonding layer interposed therebetween. Accordingly, the connection reliability of the semiconductor chips to the substrate can be improved. Further, a facility for use in the heating step can have a simplified configuration. In the case where the aforementioned heating step is performed, a bonding wire can be applied at a part required after the heating step.

Meanwhile, the method for producing a semiconductor apparatus according to this embodiment can be configured such that, in the heating step of heating at a temperature at which the sinterable particles can be sintered, the heating is performed while pressing a part or all of the plurality of semiconductor chips onto the substrate. In the method for producing a semiconductor apparatus according to this embodiment, the heating step can be configured such that the aforementioned heating is performed while pressing all of the plurality of semiconductor chips onto the substrate.

More specifically, a heating and pressing device F that is configured to be able to apply heat and includes two flat plates (i.e., parallel flat plates) disposed to, after the semiconductor chips are temporarily fixed to all of the die pads of the lead frame substrate D, sandwich a part or all of the semiconductor chips mounted on all of the die pads of the lead frame substrate D from above and below, as shown in Fig. 7B, is used. It can be configured such that the heating and pressing device F heats a part or all of the semiconductor chips mounted on all of the die pads of the lead frame substrate D at a temperature at which the sinterable particles can be sintered, while pressing (i.e., applying a pressure to) the part or all of the semiconductor chips. Fig. 7B shows an example of a heating operation which is performed while pressing all of the semiconductor chips (i.e., the first semiconductor chip B1 and the second semiconductor chip B2) mounted on all of the die pads of the lead frame substrate D (i.e., the first die pad E1 and the second die pad E2). By performing the heating step in this way, it is possible to perform the heating while pressing a part or all of the plurality of semiconductor chips onto the substrate (i.e., lead frame substrate D), and thus a part or all of the plurality of semiconductor chips can be firmly mounted on the substrate (i.e., lead frame substrate D) with the divided body 2' of the sinter bonding layer interposed therebetween. Accordingly, the connection reliability of the semiconductor chips to the substrate can be improved. In the case where the aforementioned heating step is performed, a bonding wire can be applied at a required part after the heating step.

Various types of known lead frame substrates can be adopted as the lead frame substrate D. Examples of the various types of known lead frame substrates include a lead frame substrate formed of a Cu lead frame substrate subjected to Ag plating, and a lead frame substrate (e.g., Palladium Pre Plated Lead Frame. Pd-PPF) formed by plating a Cu lead frame substrate with Ni, Pd, and Au in this order.

Matters disclosed herein by the present application include the following matters.
(1) A sinter bonding sheet including a sinter bonding layer that includes sinterable particles containing a conductive metal, and an organic binder, in which the sinter bonding layer has a first adhesive surface for being adhered to an adherend and a second adhesive surface for being adhered to another adherend, and when the value of the minimum load reached during an unloading step in a load-displacement measurement according to the nanoindentation method to the first adhesive surface is b1, and the value of the minimum load reached during the unloading step in the load-displacement measurement according to the nanoindentation method to the second adhesive surface is b2, b1 satisfies -100 µN≤M≤-35 µN and b2 satisfies -100 µN≤b2≤-35 µN.

According to the sinter bonding sheet having the above configuration, it is possible to simultaneously realize both of the sufficient transfer properties of a sinter bonding layer to a semiconductor device and the sufficient temporary fixing properties of the semiconductor device to a semiconductor device mounting area in a substrate via the sinter bonding layer.

(2) The sinter bonding sheet described in the above (1), in which
b1 satisfies -100 µN≤b1≤-45 µN, and
b2 satisfies -90 µN<b2≤-39 µN.

(3) The sinter bonding sheet described in the above (1) or (2), in which
b1 and b2 satisfy b1≤b2.

(4) The sinter bonding sheet described in any one of the above (1) to (3), in which
the organic binder includes a first organic binder and a second organic binder having a molecular weight smaller than that of the first organic binder, and
when the content percentage of the first organic binder in the sinter bonding layer is BC₁ mass% and the content percentage of the second organic binder is BC₂ mass%, BC₁ and BC₂ satisfy a relationship of BC₁:BC₂ = 6:4 to 0.5:9.5.

(5) The sinter bonding sheet described in any one of the above (1) to (4), in which the content percentage (SC) of the sinterable particles in the sinter bonding layer is 85 mass% or more and 97 mass% or less.

(6) The sinter bonding sheet described in any one of the above (1) to (5), in which
the sinter bonding layer includes a first sinter bonding layer and a second sinter bonding layer laminated on the first sinter bonding layer,
the first sinter bonding layer includes the sinterable particles and, as the organic binder, at least one of the first organic binder and the second organic binder having a molecular weight smaller than that of the first organic binder,
the second sinter bonding layer includes the sinterable particles and, as the organic binder, at least one of the first organic binder and the second organic binder,
the first sinter bonding layer and the second sinter bonding layer are different from each other in at least one of a content percentage BC₁ of a first organic binder, a content percentage BC₂ of the second organic binder, and the content percentage (SC) of the sinterable particles in the sinter bonding layer.

(7) The sinter bonding sheet described in any one of the above (1) to (6), in which
the sinterable particles contain, as the conductive metal, at least one selected from the group consisting of silver, copper, silver oxide, and copper oxide.

(8) The sinter bonding sheet described in any one of the above (1) to (7), in which
a first release liner is adhered to the first adhesive surface, and
a second release liner is adhered to the second adhesive surface.

The sinter bonding sheet according to the present invention is not limited to the aforementioned embodiment. The sinter bonding sheet according to the present invention is not limited by the aforementioned operational advantages, either. Various modifications can be made for the sinter bonding sheet according to the present invention without departing from the gist of the present invention.

### EXAMPLES

Hereinafter, the present invention will be more specifically described with reference to the examples. The following examples are provided for more specifically describing the present invention, and do not intend to limit the scope of the present invention.

### (Example 1A)

First silver particles (average particle size: 60 nm; manufactured by DOWA Electronics Materials Co., Ltd.), second silver particles (average particle size: 1100 nm; manufactured by Mitsui Mining & Smelting Co., Ltd.), a polycarbonate resin (product name "QPAC40"; manufactured by Empower Materials, Inc.), and isobornyl cyclohexanol (product name "Terusolve MTPH" manufactured by NIPPON TERPENE CHEMICALS, INC.) were dissolved or suspended in methyl ethyl ketone (MEK) at a blending ratio shown in Table 1 below, to prepare a first varnish. Stirring and mixing of the above components were performed using a hybrid mixer (model: "HM-500"; manufactured by KEYENCE CORPORATION) in the stirring mode for 3 minutes to allow these components to be dissolved or suspended in methyl ethyl ketone. The first varnish was applied at a thickness of 200 µm to a release-treated surface of a first release-treated film (product name: "MRA38" manufactured by Mitsubishi Chemical Corporation) to form a coating layer, followed by heating the coating layer at a temperature of 110 °C for 3 minutes to form a sinter bonding layer on the first release-treated film. Thereby, a first laminated sheet was obtained. Next, two first laminated sheet were placed on each other to obtain the sinter bonding sheet according to Example 1A. The exposed surfaces of the sinter bonding layers of two first laminated sheets were placed on each other (hereinafter, the exposed surface after applying the varnish for forming the sinter bonding layer may be simply referred to as an exposed surface or a varnished exposed surface). The first silver particles and the second silver particles are categorized as sinterable particles. The polycarbonate resin is categorized as the first organic binder (i.e., thermally-degradable high molecular binder). Isobornyl cyclohexanol is categorized as the second organic binder (i.e., low boiling point binder). In Table 1 below, a blending amount of the sinterable particles is represented by a value of ash, and a blending amount of each of the first silver particles and the second silver particles is represented by an amount in blending. The same applies to Table 2 and Table 3 below.

### (Example 2A)

The first varnish was applied at a thickness of 200 µm to a release-treated surface of a second release-treated film (product name: "SRD38"; manufactured by TOYOBO CO., LTD.) to form a coating layer, followed by heating the coating layer at a temperature of 110 °C for 3 minutes to form a sinter bonding layer on the second release-treated film. Thereby, a second laminated sheet was obtained. Next, two second laminated sheets were laminated on each other to obtain a sinter bonding sheet according to Example 2A. The exposed surfaces of the two second laminated sheets were placed on each other.

### (Example 3A)

One first laminated sheet and one second laminated sheet were placed on each other to obtain a sinter bonding sheet according to Example 3A. The exposed surfaces of the one first laminated sheet and the one second laminated sheet were placed on each other.

### (Example 4A)

Three first laminated sheets were placed on each other to obtain a sinter bonding sheet according to Example 4A. Three first laminated sheets were placed on each other with the following steps:
(1) The exposed surfaces of two first laminated sheet are placed on each other to obtain a laminated body having the first release-treated films disposed on both surfaces (i.e., upper and lower surfaces).
(2) One first release-treated film is peeled off from one surface of the laminated body to have one surface of the laminate exposed.
(3) The exposed surfaces of the laminated body and the remaining first release-treated film are placed on each other.

### (Comparative Example 1A)

Two first laminated sheets were placed on each other to obtain a sinter bonding sheet according to Comparative Example 1A. The two first laminated sheet were placed on each other with the following steps.
(1) The first release-treated film is peeled off from one first laminated sheet to obtain an exposed surface (hereinafter referred to as a release-forming exposed surface).
(2) A release-forming exposed surface of the first laminated sheet is placed on the exposed surface of the remaining first laminated sheet to be in abutting contact with each other.

### (Comparative Example 2A)

Two second laminated sheet were placed on each other to obtain a sinter bonding sheet according to Comparative Example 2A. Two second laminated sheets were placed on each other with the following steps.
(1) The first release-treated film together with two second laminated sheets are peeled off to obtain a release-forming exposed surface.
(2) Two second laminated sheets respectively having the release-forming exposed surfaces are placed on each other to have their release-forming exposed surfaces in abutting contact with each other.

### (Comparative Example 3A)

The first silver particles, the second silver particles, polycarbonate, and isobornyl cyclohexanol were dissolved or suspended in methyl ethyl ketone (MEK) at a blending ratio shown in Table 1 below, to prepare a second varnish. These components were stirred and mixed to be dissolved or suspended in methyl ethyl ketone in the same manner as described in the section of Example 1A. The second varnish was applied to a release-treated surface of the first release-treated film to form a coating layer, followed by heating the coating layer at a temperature of 110 °C for 3 minutes to form a sinter bonding layer on the first release-treated film. Thereby, a third laminated sheet was obtained. The third laminated sheet was employed as the sinter bonding sheet in Comparative Example 3A.

### (Comparative Example 4A)

The first silver particles, the second silver particles, and isobornyl cyclohexanol were dissolved or suspended in methyl ethyl ketone (MEK) at a blending ratio shown in Table 1 below to prepare a third varnish. That is, no polycarbonate was included in the third varnish. These components were stirred and mixed to be dissolved or suspended in methyl ethyl ketone in the same manner as described in the section of Example 1A. The third varnish was applied to a release-treated surface of the first release-treated film to form a coating layer, followed by heating the coating layer at a temperature of 110 °C for 3 minutes to form a sinter bonding layer on the first release-treated film. Thereby, a fourth laminated sheet was obtained. Next, two fourth laminated sheets were placed on each other to obtain a sinter bonding sheet according to Comparative Example 4A. The exposed surfaces of the two fourth laminated sheets were placed on each other.

**Table 1**

| | | Parts by mass | | mass% |
|---|---|---|---|---|
| First varnish | Sinterable particles | 93 | First silver particles | 90 |
| | | | Second silver particles | 10 |
| | Organic binder | 7 | Polycarbonate | 20 |
| | | | Isobornyl cyclohexanol | 80 |

| | | Parts by mass | | mass% |
|---|---|---|---|---|
| Second varnish | Sinterable particles | 93 | First silver particles | 90 |
| | | | Second silver particles | 10 |
| | Organic binder | 7 | Polycarbonate | 50 |
| | | | Isobornyl cyclohexanol | 50 |

| | | Parts by mass | | mass% |
|---|---|---|---|---|
| Third varnish | Sinterable particles | 80 | First silver particles | 90 |
| | | | Second silver particles | 10 |
| | Organic binder | 20 | Polycarbonate | 0 |
| | | | Isobornyl cyclohexanol | 100 |

### (Example 1B)

First, one first laminated sheet was obtained as described in the section of Example 1A. Next, the first silver particles, the second silver particles, polycarbonate, and isobornyl cyclohexanol were dissolved or suspended in methyl ethyl ketone at a blending ratio shown in Table 2 below to prepare a fourth varnish. These components were stirred and mixed to be dissolved or suspended in methyl ethyl ketone in the same manner as described in the section of Example 1A. The fourth varnish was applied to a release-treated surface of the first release-treated film to form a coating layer, followed by heating the coating layer at a temperature of 110 °C for 3 minutes to form a sinter bonding layer on the first release-treated film. Thereby, a fifth laminated sheet was obtained. Next, one first laminated sheet and one fifth laminated sheet were placed on each other to obtain a sinter bonding sheet according to Example 1B. The exposed surfaces of the one first laminated sheet and the one fifth laminated sheet were placed on each other.

### (Example 2B)

First, the first silver particles, the second silver particles, polycarbonate, and isobornyl cyclohexanol were dissolved or suspended in methyl ethyl ketone at a blending ratio shown in Table 2 below to prepare a fifth varnish. These components were stirred and mixed to be dissolved or suspended in methyl ethyl ketone in the same manner as described in the section of Example 1A. The fifth varnish was applied to a release-treated surface of the first release-treated film to form a coating layer, followed by heating the coating layer at a temperature of 110 °C for 3 minutes to form a sinter bonding layer on the first release-treated film. Thereby, a sixth laminated sheet was obtained. Next, the first silver particles, the second silver particles, polycarbonate, and isobornyl cyclohexanol were dissolved or suspended in methyl ethyl ketone at a blending ratio shown in Table 2 below to prepare a sixth varnish. These components were stirred and mixed to be dissolved or suspended in methyl ethyl ketone in the same manner as described in the section of Example 1A. The sixth varnish was applied to a release-treated surface of the first release-treated film to form a coating layer, followed by heating the coating layer at a temperature of 110 °C for 3 minutes to form a sinter bonding layer on the first release-treated film. Thereby, a seventh laminated sheet was obtained. Next, one sixth laminated sheet and one seventh laminated sheet were placed on each other to obtain a sinter bonding sheet according to Example 2B. The exposed surfaces of the one sixth laminated sheet and the one seventh laminated sheet were placed on each other.

### (Example 3B)

First, one first laminated sheet was obtained as described in the section of Example 1A. Next, the first silver particles, the second silver particles, polycarbonate, and isobornyl cyclohexanol were dissolved or suspended in methyl ethyl ketone at a blending ratio shown in Table 2 below to prepare a seventh varnish. These components were stirred and mixed to be dissolved or suspended in methyl ethyl ketone in the same manner as described in the section of Example 1A. The seventh varnish was applied to a release-treated surface of the first release-treated film to form a coating layer, followed by heating the coating layer at a temperature of 110 °C for 3 minutes to form a sinter bonding layer on the first release-treated film. Thereby, an eighth laminated sheet was obtained. Next, one first laminated sheet and one eighth laminated sheet were placed on each other to obtain a sinter bonding sheet according to Example 3B. The exposed surfaces of the one first laminated sheet and the one eighth laminated sheet were placed on each other.

### (Example 4B)

First, one eighth laminated sheet was obtained as described in the section of Example 3B. Next, the first silver particles, the second silver particles, polycarbonate, and isobornyl cyclohexanol were dissolved or suspended in methyl ethyl ketone at a blending ratio shown in Table 2 below to prepare an eighth varnish. These components were stirred and mixed to be dissolved or suspended in methyl ethyl ketone in the same manner as described in the section of Example 1A. The eighth varnish was applied to a release-treated surface of the first release-treated film to form a coating layer, followed by heating the coating layer at a temperature of 110 °C for 3 minutes to form a sinter bonding layer on the first release-treated film. Thereby, a ninth laminated sheet was obtained. Next, one eighth laminated sheet and one ninth laminated sheet were placed on each other to obtain a sinter bonding sheet according to Example 4B. The exposed surfaces of the one eighth laminated sheet and the one ninth laminated sheet were placed on each other.

### (Comparative Example 1B)

First, one first laminated sheet was obtained as described in the section of Example 1A. Next, the first silver particles, the second silver particles, polycarbonate, and isobornyl cyclohexanol were dissolved or suspended in methyl ethyl ketone at a blending ratio shown in Table 2 below to prepare a ninth varnish. These components were stirred and mixed to be dissolved or suspended in methyl ethyl ketone in the same manner as described in the section of Example 1A. The ninth varnish was applied to a release-treated surface of the first release-treated film to form a coating layer, followed by heating the coating layer at a temperature of 110 °C for 3 minutes to form a sinter bonding layer on the first release-treated film. Thereby, a tenth laminated sheet was obtained. Next, one first laminated sheet and one tenth laminated sheet were placed on each other to obtain a sinter bonding sheet according to Comparative Example 1B. The exposed surfaces of the one first laminated sheet and the one tenth laminated sheet were placed on each other.

### (Comparative Example 2B)

First, the first silver particles, the second silver particles, and isobornyl cyclohexanol were dissolved or suspended in methyl ethyl ketone (MEK) at a blending ratio shown in Table 2 below to prepare a tenth varnish. That is, no polycarbonate was included in the tenth varnish. These components were stirred and mixed to be dissolved or suspended in methyl ethyl ketone in the same manner as described in the section of Example 1A. The tenth varnish was applied to a release-treated surface of the first release-treated film to form a coating layer, followed by heating the coating layer at a temperature of 110 °C for 3 minutes to form a sinter bonding layer on the first release-treated film. Thereby, an eleventh laminated sheet was obtained. Next, one tenth laminated sheet was obtained as described in the section of Example 2B. Then, one eleventh laminated sheet and one tenth laminated sheet were placed on each other to obtain a sinter bonding sheet according to Comparative Example 2B. The exposed surfaces of the one eleventh laminated sheet and the one tenth laminated sheet were placed on each other.

**Table 2**

| | | Parts by mass | | mass% | |
|---|---|---|---|---|---|
| Fourth varnish | Sinterable particles | 93.8 | First silver particles | 90 | |
| | | | Second silver particles | 10 | |
| | Organic binder | 6.2 | Polycarbonate | 20 | |
| | | | Isobornyl cyclohexanol | 80 | |

| | | Parts by mass | | mass% | |
|---|---|---|---|---|---|
| Fifth varnish | Sinterable particles | 93 | First silver particles | 90 | |
| | | | Second silver particles | 10 | |
| | Organic binder | 7 | Polycarbonate | 40 | |
| | | | Isobornyl cyclohexanol | 60 | |

| | | Parts by mass | | mass% | |
|---|---|---|---|---|---|
| Sixth varnish | Sinterable particles | 94 | First silver particles | 90 | |
| | | | Second silver particles | 10 | |
| | Organic binder | 6 | Polycarbonate | 20 | |
| | | | Isobornyl cyclohexanol | 80 | |

| | | Parts by mass | | mass% | |
|---|---|---|---|---|---|
| Seventh varnish | Sinterable particles | 92.7 | First silver particles | 90 | |
| | | | Second silver particles | 10 | |
| | Organic binder | 7.3 | Polycarbonate | 20 | |
| | | | Isobornyl cyclohexanol | 80 | |

| | | Parts by mass | | mass% | |
|---|---|---|---|---|---|
| Eighth varnish | Sinterable particles | 93 | First silver particles | 90 | |
| | | | Second silver particles | 10 | |
| | Organic binder | 7 | Polycarbonate | 5 | |
| | | | Isobornyl cyclohexanol | 95 | |

| | | Paris by mass | | mass% | |
|---|---|---|---|---|---|
| Ninth varnish | Sinterable particles | 92.5 | First silver particles | 90 | |
| | | | Second silver particles | 10 | |
| | Organic binder | 7.5 | Polycarbonate | 20 | |
| | | | Isobornyl cyclohexanol | 80 | |

| | | Paris by mass | | mass% | |
|---|---|---|---|---|---|
| Tenth varnish | Sinterable particles | 93 | First silver particles | 90 | |
| | | | Second silver particles | 10 | |
| | Organic binder | 7 | Polycarbonate | 0 | |
| | | | Isobornyl cyclohexanol | 100 | |

### (Example 1C)

First, the first silver particles, the second silver particles, and isobornyl cyclohexanol were dissolved or suspended in methyl ethyl ketone (MEK) at a blending ratio shown in Table 3 below to prepare an eleventh varnish. These components were stirred and mixed to be dissolved or suspended in methyl ethyl ketone in the same manner as described in the section of Example 1A. The eleventh varnish was applied to a release-treated surface of the first release-treated film to form a coating layer, followed by heating the coating layer at a temperature of 110 °C for 3 minutes to form a sinter bonding layer on the first release-treated film. Thereby, a twelfth laminated sheet was obtained. Next, one first laminated sheet was obtained as described in the section of Example 1A. Then, one twelfth laminated sheet and one first laminated sheet were placed on each other to obtain a sinter bonding sheet according to Example 1C. The exposed surfaces of the one twelfth laminated sheet and the one first laminated sheet were placed on each other.

### (Example 2C)

First, one first laminated sheet was obtained as described in the section of Example 1A. Next, the first silver particles, the second silver particles, polycarbonate, and isobornyl cyclohexanol were dissolved or suspended in methyl ethyl ketone (MEK) at a blending ratio shown in Table 3 below to prepare a twelfth varnish. These components were stirred and mixed to be dissolved or suspended in methyl ethyl ketone in the same manner as described in the section of Example 1A. The twelfth varnish was applied to a release-treated surface of the first release-treated film to form a coating layer, followed by heating the coating layer at a temperature of 110 °C for 3 minutes to form a sinter bonding layer on the first release-treated film. Thereby, a thirteenth laminated sheet was obtained. Then, one first laminated sheet and one thirteenth laminated sheet were placed on each other to obtain a sinter bonding sheet according to Example 2C. The exposed surfaces of the one first laminated sheet and the one thirteenth laminated sheet were placed on each other.

### (Example 3C)

The first silver particles, the second silver particles, polycarbonate, and isobornyl cyclohexanol were dissolved or suspended in methyl ethyl ketone (MEK) at a blending ratio shown in Table 3 below to prepare a thirteenth varnish. These components were stirred and mixed to be dissolved or suspended in methyl ethyl ketone in the same manner as described in the section of Example 1A. The thirteenth varnish was applied to a release-treated surface of the first release-treated film to form a coating layer, followed by heating the coating layer at a temperature of 110 °C for 3 minutes to form a sinter bonding layer on the first release-treated film. Thereby, a fourteenth laminated sheet was obtained. Then, two fourteenth laminated sheets were placed on each other to obtain a sinter bonding sheet according to Example 3C. The exposed surfaces of the two fourteenth laminated sheets were placed on each other.

### (Example 4C)

First, one first laminated sheet was obtained as described in the section of Example 1A. Next, one seventh laminated sheet was obtained as described in the section of Example 2B. Then, the one first laminated sheet and the one seventh laminated sheet were placed on each other to obtain a sinter bonding sheet according to Example 4C. The exposed surfaces of the one first laminated sheet and the one seventh laminated sheet were placed on each other.

### (Example 5C)

First, one first laminated sheet was obtained as described in the section of Example 1A. Next, one eighth laminated sheet was obtained as described in the section of Example 3B. Then, the one first laminated sheet and the one eighth laminated sheet were placed on each other to obtain a sinter bonding sheet according to Example 5C. The exposed surfaces of the one first laminated sheet and the one eighth laminated sheet were placed on each other.

### (Example 6C)

Two eighth laminated sheets were obtained as described in the section of Example 3B. Then, the two eighth laminated sheets were placed on each other to obtain a sinter bonding sheet according to Example 6C. The exposed surfaces of the two eighth laminated sheets were placed on each other.

**Table 3**

| | | Parts by mass | | mass% |
|---|---|---|---|---|
| Eleventh varnish | Sinterable particles | 93 | First silver particles | 90 |
| | | | Second silver particles | 10 |
| | Organic binder | 7 | Polycarbonate | 30 |
| | | | Isobornyl cyclohexanol | 70 |

| | | Parts by mass | | mass% |
|---|---|---|---|---|
| Twelfth varnish | Sinterable particles | 93 | First silver particles | 90 |
| | | | Second silver particles | 10 |
| | Organic binder | 7 | Polycarbonate | 10 |
| | | | Isobornyl cyclohexanol | 90 |

| | | Parts by mass | | mass% |
|---|---|---|---|---|
| Thirteenth varnish | Sinterable particles | 93 | First silver particles | 90 |
| | | | Second silver particles | 10 |
| | Organic binder | 7 | Polycarbonate | 50 |
| | | | Isobornyl cyclohexanol | 50 |

### <Measurement of minimum load>

The minimum load reached during an unloading step in a load-displacement measurement according to the nanoindentation method was obtained for each surface (i.e., the first adhesive surface and the second adhesive surface) of the sinter bonding sheet according to each of the Examples and Comparative Examples. The minimum load was measured according to the method described in the above Examples. The results are shown in Table 4 below.

Each of the sinter bonding sheet according to Example 1A, the sinter bonding sheet according to Example 2A, the sinter bonding sheet according to Example 4A, the sinter bonding sheet according to Comparative Example 2A, and the sinter bonding sheet according to Comparative Example 4Ais formed by the same laminated sheets placed on each other, so that one exposed surface obtained by peeling of the release-treated film and another exposed surface of the sinter bonding sheet are respectively served as the first adhesive surface and the second adhesive surface. In the sinter bonding sheet according to Example 3A, the surface on the side of the second laminated sheet is served as the first adhesive surface, and the surface on the side of the first laminated sheet is served as the second adhesive surface. In the sinter bonding sheet according to Comparative Example 1A, the exposed surface (i.e., varnished exposed surface) is served as the first adhesive surface, and the exposed surface obtained by peeling of the first release-treated film (i.e., release-forming exposed surface) is served as the second adhesive surface. In the sinter bonding sheet according to Comparative Example 3A, the exposed surface obtained by peeling of the first release-treated film (i.e., release-forming exposed surface) is served as the first adhesive surface, and the exposed surface (i.e., varnished exposed surface) is served as the second adhesive surface.

In the sinter bonding sheet according to Example 1B, the surface on the side of the first laminated sheet is served as the first adhesive surface, and the surface on the side of the fifth laminated sheet is served as the second adhesive surface. In the sinter bonding sheet according to Example 2B, the surface on the side of the sixth laminated sheet is served as the first adhesive surface, and the surface on the side of the seventh laminated sheet is served as the second adhesive surface. In the sinter bonding sheet according to Example 3B, the surface on the side of the first laminated sheet is served as the first adhesive surface, and the surface on the side of the eighth laminated sheet is served as the second adhesive surface. In the sinter bonding sheet according to Example 4B, the surface on the side of the eighth laminated sheet is served as the first adhesive surface, and the surface on the side of the ninth laminated sheet is served as the second adhesive surface. In the sinter bonding sheet according to Comparative Example 1B, the surface on the side of the first laminated sheet is served as the first adhesive surface, and the surface on the side of the tenth laminated sheet is served as the second adhesive surface. In the sinter bonding sheet according to Comparative Example 2B, the surface on the side of the eleventh laminated sheet is served as the first adhesive surface, and the surface on the side of the tenth laminated sheet is served as the second adhesive surface.

In the sinter bonding sheet according to Example 1C, the surface on the side of the twelfth laminated sheet is served as the first adhesive surface, and the surface on the side of the first laminated sheet is served as the second adhesive surface. In the sinter bonding sheet according to Example 2C, the surface on the side of the first laminated sheet is served as the first adhesive surface, and the surface on the side of the thirteenth laminated sheet is served as the second adhesive surface. In the sinter bonding sheet according to Example 4C, the surface on the side of the first laminated sheet is served as the first adhesive surface, and the surface on the side of the seventh laminated sheet is served as the second adhesive surface. In the sinter bonding sheet according to Example 5C, the surface on the side of the eighth laminated sheet is served as the first adhesive surface, and the surface on the side of the first laminated sheet is served as the second adhesive surface. In the sinter bonding sheet according to Example 3C and the sinter bonding sheet according to Example 6C, both of which are formed by the same laminated sheets placed on each other, the exposed surface on one side obtained by peeling of a release-treated film is served as the first adhesive surface, and the exposed surface on the other side is served as the second adhesive surface.

**Table 4**

| | Ex. 1A | Ex. 2A | Ex. 3A | Ex. 4A | C. Ex. 1A | C. Ex. 2A | C. Ex. 3A | C. Ex. 4A |
|---|---|---|---|---|---|---|---|---|
| Minim um load b1 of first adhesive surface [µN] | -70.7 | -83.2 | -83.2 | -70.7 | -33.1 | -33.1 | -38.1 | -114.0 |
| Minimum load b2 of second adhesive surface [µN] | -70.7 | -83.2 | -70.7 | -70.7 | -70.7 | -33.1 | -33.1 | -114.0 |
| | Ex. 1B | Ex. 2B | Ex. 3B | Ex. 4B | C. Ex. 18 | C. Ex. 2B | | |
| Minimum load b1 of first adhesive surface [µN] | -70.7 | -47.3 | -70.7 | -95.4 | -70.7 | -104.1 | | |
| Minimum load b2 of second adhesive surface [µN] | -45.2 | -39.5 | -95.4 | -94.3 | -109.3 | -109.3 | | |
| | Ex. 1C | Ex. 2C | Ex. 3C | Ex. 4C | Ex. 5C | Fx. 6C | | |
| Minim um load b1 of first adhesive surface [µN] | -57.6 | -70.7 | -38.9 | -70.7 | -95.4 | -95.4 | | |
| Minimum load b2 of second adhesive surface [µN] | -70.7 | -85.5 | -38.9 | -39.5 | -70.7 | -95.4 | | |

### <Evaluation of transfer properties and temporary fixing properties>

For the sinter bonding sheet according to each of the Examples and Comparative Examples, the transfer properties of the first adhesive surface and the temporary fixing properties of the second adhesive surface were respectively evaluated.

Evaluation of the transfer properties was performed with the following steps.
(1) For the sinter bonding sheet according to each of the Examples and Comparative Examples, a first adhesive surface is exposed by peeling the release-treated film off from the side of the first adhesive surface.
(2) Five Si chips (plated with Ag; thickness: 200 µm) each having a 5 mm square size are placed at 5 mm intervals on the first adhesive surface of the sinter bonding sheet according to each of the Examples and Comparative Examples.
(3) The sinter bonding sheet according to each of the Examples and Comparative Examples, in which the five Si chips are placed on the first adhesive surface, is passed through a laminator equipped with a pressure roll, to allow the five Si chips to be press-bonded to the first adhesive surface. The press-bonding is performed at a temperature of 70 °C, a roll pressure of 0.5 MPa, and a rolling speed of 10 mm/sec.
(4) A release-treated film is peeled off from the side of the second adhesive surface of the sinter bonding sheet according to each of the Examples and Comparative Examples. Then, visual observation is made on the transferred size of the sinter bonding layer of the sinter bonding sheet to evaluate the transfer properties based on the following criteria.
   Excellent: The sinter bonding layer is transferred with the same size as the Si chips
   Bad: The sinter bonding layer is not transferred due to the lack of tight contact with the Si chips.

Evaluation of the temporary fixing properties was performed with the following steps.
(1) The sinter bonding sheet according to the Examples and Comparative Examples is cut out to a 10 mm square size, then the release-treated film is peeled off from the side of the second adhesive surface to expose the second adhesive surface.
(2) The second adhesive surface of the sinter bonding sheet according to the Examples and Comparative Examples which is cut out to a 10 mm square size is allowed to come into contact with a surface of a solid copper (Cu) substrate, then is pressed at a temperature of 50 °C, and a pressure of 0.1 MPa and a pressure of 0.5 MPa for 10 seconds. Thereby, a sample for evaluation of temporary fixing properties is obtained.
(3) The sample for evaluation of temporary fixing properties is held to have the plane direction of the solid copper substrate extending along the vertical direction. Then, the temporary fixing properties are evaluated with the following criteria.
   Excellent: The sinter bonding sheet does not fall at a pressure of 0.1 MPa
   Good: The sinter bonding sheet falls at a pressure of 0.1 MPa, but does not fall at a pressure of 0.5 MPa.
   Bad: The sinter bonding sheet falls at a pressure of 0.5 MPa. Or, a so-called "naki-wakare" (peeling off at an undesirable site) is observed in the sinter bonding layer when the second adhesive surface is exposed.

Table 5 below shows, for the sinter bonding sheet according to each of the Examples and Comparative Examples, the evaluation results of the transfer properties of the first adhesive surface and the evaluation results of the temporary fixing properties of the second adhesive surface.

**Table 5**

| | Ex. 1A | Ex. 2A | Ex. 3A | Ex. 4A | C. Ex. 1A | C. Ex. 2A | C. Ex. 3A | C. Ex. 4A |
|---|---|---|---|---|---|---|---|---|
| Transfer properties | Excellent | Excellent | Excellent | Excellent | Bad | Bad | Excellent | Bad |
| Temporary fixing properties | Excellent | Excellent | Excellent | Excellent | Excellent | Bad | Bad | Bad |
| | Ex. 1B | Ex. 2B | Ex. 3B | Ex. 4B | C. Ex. 1B | C. Ex. 2B | | |
| Transfer properties | Excellent | Excellent | Excellent | Excellent | Excellent | Excellent | | |
| Temporary fixing properties | Good | Good | Excellent | Excellent | Bad | Bad | | |
| | Ex. 1C | Ex. 2C | Ex. 3C | Ex. 4C | Ex. 5C | Ex. 6C | | |
| Transfer properties | Excellent | Excellent | Excellent | Excellent | Excellent | Excellent | | |
| Temporary fixing properties | Excellent | Excellent | Good | Good | Excellent | Excellent | | |

As is evident from Table 5, good results are obtained in the sinter bonding sheets according to the Examples for both of the transfer properties and the temporary fixing properties, whereas the evaluation results are bad for at least one of the transfer properties and the temporary fixing properties in the sinter bonding sheets according to the Comparative Examples.

### REFERENCE SIGNS LIST

1: Substrate layer
2: Sinter bonding layer
10: Sinter bonding sheet
2A: First adhesive surface
2b: Second adhesive surface
2A: First sinter bonding layer
2B: Second sinter bonding layer

## Claims

1. A sinter bonding sheet comprising a sinter bonding layer that comprises sinterable particles containing a conductive metal, and an organic binder, wherein
the sinter bonding layer has a first adhesive surface for being adhered to an adherend and a second adhesive surface for being adhered to another adherend, and
when the value of the minimum load reached during an unloading step in a load-displacement measurement according to the nanoindentation method to the first adhesive surface is b1, and the value of the minimum load reached during the unloading step in the load-displacement measurement according to the nanoindentation method to the second adhesive surface is b2, b1 satisfies -100 µN≤b1≤-35 µN and b2 satisfies -100 µN≤b2≤-35 µN.

2. The sinter bonding sheet according to claim 1, wherein
b1 satisfies -100 µN≤b1≤-45 µN, and
b2 satisfies -90 µN<b2≤-39 µN.

3. The sinter bonding sheet according to claim 1 or 2, wherein
b1 and b2 satisfy b1≤b2.

4. The sinter bonding sheet according to any one of claims 1 to 3, wherein
the organic binder comprises a first organic binder and a second organic binder having a molecular weight smaller than that of the first organic binder, and
when the content percentage of the first organic binder in the sinter bonding layer is BC₁ mass% and the content percentage of the second organic binder is BC₂ mass%, BC₁ and BC₂ satisfy a relationship of BC₁:BC₂ = 6:4 to 0.5:9.5.

5. The sinter bonding sheet according to any one of claims 1 to 4, wherein
the content percentage (SC) of the sinterable particles in the sinter bonding layer is 85 mass% or more and 97 mass% or less.

6. The sinter bonding sheet according to any one of claims 1 to 5, wherein
the sinter bonding layer comprises a first sinter bonding layer and a second sinter bonding layer laminated on the first sinter bonding layer,
the first sinter bonding layer comprises the sinterable particles and, as the organic binder, at least one of the first organic binder and the second organic binder having a molecular weight smaller than that of the first organic binder,
the second sinter bonding layer comprises the sinterable particles and, as the organic binder, at least one of the first organic binder and the second organic binder,
the first sinter bonding layer and the second sinter bonding layer are different from each other in at least one of a content percentage BC₁ of the first organic binder, a content percentage BC₂ of the second organic binder, and a content percentage (SC) of the sinterable particles in the sinter bonding layer.

7. The sinter bonding sheet according to any one of claims 1 to 6, wherein
the sinterable particles contain, as the conductive metal, at least one selected from the group consisting of silver, copper, silver oxide, and copper oxide.

8. The sinter bonding sheet according to any one of claims 1 to 7, wherein
a first release liner is adhered to the first adhesive surface, and
a second release liner is adhered to the second adhesive surface.
